# EUROPÄISCHE PATENTANMELDUNG

(11) **EP 1 959 571 A2**
(43) Veröffentlichungstag der Anmeldung: **20.08.2008**
(21) Anmeldenummer: 08001571.2
(22) Anmeldetag: 29.01.2008
(51) Int. Cl.: H03K 17/975

(54) **Sensorelement für einen Berührungsschalter, Herstellungsverfahren und Berührungsschaltereinrichtung mit solchen Sensorelementen**

(30) Priorität: 12.02.2007 DE 102007008178
(71) Anmelder: E.G.O. ELEKTRO-GERÄTEBAU GmbH, 75038 Oberderdingen (DE)
(72) Erfinder: Winkler, Uwe, 76275 Ettlingen (DE)
(74) Vertreter: Patentanwälte Ruff, Wilhelm, Beier, Dauster & Partner

(57) **Zusammenfassung**

Ein Sensorelement (20) für eine Berührungsschaltereinrichtung (11) weist einen Sensorelementkörper (21) aus elastischem Material auf. Der Sensorelementkörper (21) weist zwei parallele Stirnwandbereiche (23a/b) als Deckfläche und Bodenfläche auf, die über nach innen gewölbte Seitenwandbereiche (25a/b) einstückig und einteilig miteinander verbunden sind. Ein solcher Sensorelementkörper (21) kann sehr leicht zusammengedrückt werden. Eine Wandstärke der Wandbereiche (23a/b, 25a/b) ist im Wesentlichen überall gleich.

## Beschreibung

Die Erfindung betrifft ein Sensorelement für einen Berührungsschalter, insbesondere einen kapazitiven Berührungsschalter, ein Verfahren zur Herstellung eines solchen Sensorelements sowie eine Berührungsschalteinrichtung mit solchen Sensorelementen.

Aus der EP 859 467 A1 sind solche Sensorelemente für kapazitive Berührungsschalter grundsätzlich bekannt.

Aus der DE 102 50 395 A1 ist es bekannt, bei einem länglichen, rundzylindrischen Sensorelement für einen kapazitiven Berührungsschalter eine querverlaufende Bohrung vorzusehen. Dies weist den Vorteil auf, dass dadurch die Elastizität des Sensorelements erhöht wird bzw. das Sensorelement sozusagen weicher gemacht wird und leichter zusammengedrückt werden kann.

### Aufgabe und Lösung

Der Erfindung liegt die Aufgabe zugrunde, ein eingangs genanntes Sensorelement, ein Verfahren zu seiner Herstellung sowie eine damit versehene Berührungsschaltereinrichtung zu schaffen, mit denen Probleme des Standes der Technik vermieden werden können und durch die insbesondere ein leicht herstellbares sowie einfach zu montierendes und zu verwendendes Sensorelement geschaffen werden kann.

Gelöst wird diese Aufgabe durch ein Sensorelement mit den Merkmalen des Anspruchs 1, eine mit derartigen Sensorelementen versehene Berührungsschaltereinrichtung mit den Merkmalen des Anspruchs 15 sowie ein Verfahren zur Herstellung eines solchen Sensorelements mit den Merkmalen des Anspruchs 17. Vorteilhafte sowie bevorzugte Ausgestaltungen der Erfindung sind Gegenstand der weiteren Ansprüche und werden im Folgenden näher erläutert. Manche der Merkmale werden zwar nur getrennt für Sensorelement, Berührungsschaltereinrichtung oder Verfahren beschrieben. Sie sollen jedoch unabhängig davon für sämtliche Ausgestaltungen gelten können. Der Wortlaut der Ansprüche wird dabei durch ausdrückliche Bezugnahme zum Inhalt der Beschreibung gemacht.

Es ist vorgesehen, dass das Sensorelement einen Sensorelementkörper aus elastischem Material aufweist. Der Sensorelementkörper weist, zumindest dann, wenn er in den Berührungsschalter oder eine Berührungsschaltereinrichtung eingebaut ist, eine obere Deckfläche und eine dieser gegenüberliegende untere Bodenfläche auf, die vorteilhaft im Wesentlichen parallel zueinander oder leicht schräg zueinander stehend sind. Eine dieser Flächen kann auch konvex oder konkav gewölbt gebogen sein, vorteilhaft die Deckfläche. Erfindungsgemäß ist das Sensorelement kastenartig ausgebildet und weist zusammenhängende Wandbereiche auf, die um einen größeren Zwischenraum herum verlaufen. Dabei werden die Deckfläche und die Bodenfläche je von einem Stirnwandbereich gebildet, wobei diese beiden Wandbereiche über Zwischenwandbereiche bzw. Seitenwände miteinander verbunden sind. Vorteilhaft kann dabei vorgesehen sein, dass der Zwischenraum einen Großteil des Querschnitts des gesamten Sensorelementkörpers einnimmt, beispielsweise 70% bis 90%.

So wird ein Sensorelement mit einem Sensorelementkörper geschaffen, welches durch den besonders großen Zwischenraum sehr elastisch bzw. flexibel ist und sehr leicht bzw. mit geringen Kräften zusammengedrückt werden kann. Beim Zusammendrücken geben vor allem die Seitenwandbereiche nach. Dies kann unterschiedlich erfolgen, wie nachfolgend noch näher erläutert wird.

In Ausgestaltung der Erfindung kann vorgesehen sein, dass die Wandstärken der Wandbereiche über einen Großteil ihrer Fläche im Wesentlichen gleich sind bzw. sich nicht verändern. Bevorzugt können sie auch jeweils etwa gleich sein. Besonders bevorzugt gilt dies auch für die Seitenwandbereiche, so dass auch diese eine im Wesentlichen gleichbleibende und gleiche Wandstärke aufweisen. Es ist möglich, die Wandstärken der Seitenwandbereiche relativ dünn auszubilden, so dass die Sensorelemente leicht zusammengedrückt werden können. Vorteilhaft sind gegenüberliegende Wandbereiche gleich bzw. spiegelbildlich ausgebildet. So können für ein Zusammendrücken gleichbleibende bzw. unabhängig von der Einbauorientierung gleiche elastische Eigenschaften erreicht werden.

In weiterer Ausgestaltung der Erfindung ist es möglich, dass die Wandstärken der Deckfläche und der Bodenfläche ähnlich sind wie die Wandstärken der Seitenwandbereiche. Da sich die Form dieser beiden Flächen selbst bei einem geringen Zusammendrücken möglichst nicht ändern sollte bzw. diese in etwa eben bleiben sollten, die Seitenwandbereiche jedoch entweder elastisch gestaucht werden oder nach innen oder nach außen weggebogen werden, können hier vorteilhaft Materialverdünnungen als eine Art Gelenk vorgesehen werden. Besonders vorteilhaft sind diese Materialverdünnungen an Deckfläche und Bodenfläche vorgesehen, und zwar vorzugsweise so weit außen, dass sich die Seitenwandbereiche in ihrer Wandstärke nicht ändern.

In Ausgestaltung der Erfindung kann eine Wandstärke eines Seitenwandbereichs etwa 5% bis 10% der Breite oder Höhe des Sensorelements betragen. Als Wandstärke bieten sich etwa 0,5mm bis 2mm an.

In bevorzugter Ausgestaltung der Erfindung sind Deckfläche und Bodenfläche eben und parallel zueinander ausgebildet und zwar im Wesentlichen auch im nicht eingebauten bzw. nicht zusammengedrückten Zustand. Die Seitenwandbereiche sind gewölbt oder wölbungsartig ausgebildet. Einerseits können sie von einer Mitte des Sensorelements bzw. von dem Zwischenraum weg nach außen gewölbt sein. Beim Zusammendrücken wölben sich die Seitenwandbereiche in diese Richtung noch stärker. Eine derartige Wölbung kann zwischen 5% und 20% der Breite des Sensorelements betragen, unter Umständen sogar noch mehr. Alternativ zu einer Wölbung nach außen können die Seitenwandbereiche in ähnlichem Maß auch nach innen gewölbt sein. Um ein seitliches Versetzen von Deckfläche und Bodenfläche beim Zusammendrücken zueinander zu vermeiden ist es wiederum vorteilhaft, die Seitenwandbereiche spiegelbildlich auszubilden, also entweder beide nach innen oder beide nach außen gewölbt. Eine Wölbung kann einerseits im Wesentlichen gleichmäßig bzw. eine Rundung sein. Andererseits kann auch eine Art geknickter Verlauf im Wesentlichen dieselbe Wirkung wie eine runde Wölbung hervorrufen, wobei durch einen derartigen geknickten Verlauf unter Umständen das Sensorelement nochmals leichter zusammengedrückt werden kann.

Bei gewölbten Seitenwandbereichen kann vorgesehen sein, dass ein Seitenwandbereich und Deckfläche oder Bodenfläche in einem Winkel von 35° bis 80° zueinander stehen, bevorzugt in einem Winkel von 40° bis 70°. Ein Seitenwandbereich steht dann also schräg von Deckfläche oder Bodenfläche ab zur weiteren Verbesserung der Zusammendrückbarkeit. Vorteilhaft ist vorgesehen, dass sämtliche Verbindungen zwischen Deckfläche und Bodenfläche und den Seitenwandbereichen gleich ausgebildet sind bzw. den gleichen Winkel zueinander aufweisen.

In weiterer Ausgestaltung der Erfindung kann vorgesehen sein, dass nicht einfach nur jeweils ein Seitenwandbereich nach innen oder nach außen gewölbt ist, sondern diese sozusagen doppelwandig ausgebildet sind und beispielsweise zwei Teilseitenwandbereiche aufweisen. Diese Teilseitenwandbereiche können voneinander weggewölbt sein, also eine Art Bauch zwischen sich bilden, wobei sie an ihren Enden miteinander verbunden sind. Auf diese Art und Weise kann im Wesentlichen vermieden werden, dass beim Zusammendrücken des Sensorelementkörpers und dem folgenden stärkeren Wölben eines Seitenwandbereichs ein Drehmoment über den Verbindungsbereich auf Deckfläche oder Bodenfläche übertragen wird, vor allem auf die Deckfläche. Dies kann noch dadurch verbessert werden, dass die Verbindung der Enden der Teilseitenwandbereiche im Wesentlichen dort liegt, wo sie mit Deckfläche oder Bodenfläche verbunden sind. So wird ein gutes und möglichst vollflächiges Anliegen an einer Abdeckung oder Bedienfläche gewährleistet.

In einer alternativen grundsätzlichen Ausgestaltung der Erfindung kann vorgesehen sein, dass Deckfläche oder Bodenfläche gebogen bzw. gewölbt ausgebildet sind, insbesondere nach außen gewölbt, vor allem die Deckfläche. Dadurch kann eine Anpassung an eine entsprechend gewölbte Abdeckung oder Bedienfläche erreicht werden. Abgesehen davon kann ein solcher Sensorelementkörper jedoch gleich ausgebildet sein wie vorstehend und nachfolgend beschrieben.

Vorteilhaft sind die Seitenwandbereiche eines Sensorelementkörpers gleich bzw. vor allem auch ähnlich lang ausgebildet. Sie können jedoch auch unterschiedlich lang sein, wodurch es beim Einbau in eine erfindungsgemäße Berührungsschaltereinrichtung möglich ist, dass ein Träger für den Sensorelementkörper, wie beispielsweise eine Leiterplatte, nicht parallel zu der darüber verlaufenden Bedienfläche verlaufen muss bzw. schräg dazu verlaufen kann.

Hergestellt werden kann ein solches Sensorelement im Wesentlichen wie aus dem Stand der Technik bekannt, also aus einem offenporigen oder geschlossenporigen Elastomer bzw. einem Polymer. Hierfür bieten sich Silikon bzw. Silikon-Polymer an. Des Weiteren sollte das Sensorelement elektrisch leitfähig sein, wobei auch hierzu auf den Stand der Technik verwiesen wird, insbesondere auf die eingangs genannte DE 102 503 95 A1 oder die EP 859 467 A1.

Es kann vorgesehen sein, dass im eingebauten Zustand die Deckfläche, die die Berührungsfläche für den Berührungsschalter bildet oder ein Teil des Berührungsschalters ist, größer ist als die Bodenfläche, die eine elektrische Kontaktierung bzw. einen elektrischen Anschluss bildet. Dies kann aber auch umgekehrt sein.

In Ausgestaltung der Erfindung kann vorgesehen sein, dass in Deckfläche und Bodenfläche wenigstens eine axial fluchtende Ausnehmung vorgesehen ist, also eine Art Durchbohrung oder Durchbruch, wie dies für Sensorelementkörper gemäß der vorgenannten EP 859 467 A1 bekannt ist. Eine solche Ausnehmung kann für eine Durchleuchtung verwendet werden. Sie kann durch einen Mittelpunkt des Sensorelements verlaufen und etwa 10% bis 80% der Fläche von Deckfläche oder Bodenfläche betragen.

In nochmals weiterer Ausgestaltung der Erfindung kann vorgesehen sein, dass sich von Deckfläche oder Bodenfläche in den Zwischenraum hinein ein Vorsprung erstreckt bzw. davon absteht. Ein solcher Vorsprung geht auf die gegenüberliegende Fläche zu, weist dazu jedoch einen Abstand auf, wobei seine Höhe etwa 40% bis 80% des Abstands der Flächen voneinander im nicht zusammengedrückten Zustand beträgt. Dieser Vorsprung kann dazu dienen, eine Art maximale Zusammendrückbarkeit zu definieren. Ein solcher Sensorelementkörper kann also relativ leicht so weit zusammengedrückt werden, bis der Vorsprung auch an der gegenüberliegenden Fläche anliegt. Ab diesem Punkt ist ein weiteres Zusammendrücken zwar noch möglich, jedoch nur unter erheblich größerem Kraftaufwand, weil dann auch der Vorsprung elastisch zusammengedrückt werden muss.

Bei einer mit mehreren vorbeschriebenen Sensorelementen bzw. Sensorelementkörpern versehenen Berührungsschaltereinrichtung sind die Sensorelemente nebeneinander bzw. mit Abstand zueinander auf einem Träger angeordnet. Ein solcher Träger kann eine Leiterplatte sein, auf der insbesondere auch eine Ansteuerung und/oder Auswertung für die Berührungsschaltereinrichtung vorgesehen ist. Eine elektrische Kontaktierung kann über den Träger an die Sensorelemente erfolgen wie aus dem Stand der Technik bekannt. Mit der Bodenfläche liegen die Sensorelementkörper also auf dem Träger auf und mit der Deckfläche liegen sie an einer mit gewissem Abstand darüber verlaufenden Bedienfläche an, wobei sich die Deckfläche möglichst vollflächig an die Bedienfläche anschmiegt bzw. anpasst. Der Hohlraum des Sensorelementkörpers erstreckt sich axial zwischen dem Träger und der Bedienfläche. Vorteilhaft sind sämtliche Sensorelemente einer Berührungsschaltereinrichtung zumindest vom Grundaufbau her gleich.

Die Sensorelemente können auf den Träger aufgeklebt sein, wofür sich insbesondere doppelseitiges Klebeband anbietet. Dieses kann zuerst auf dem Träger fixiert sein und dann ein Sensorelement aufgesetzt werden. Alternativ und bevorzugt wird das Klebeband zuerst am Sensorelement angebracht. Es ist möglich, einzelne bzw. abgeschnittene Sensorelemente auf einem länglichen doppelseitigen Klebeband mit Abdeckstreifen anzuordnen. Davon können sie dann abgelöst werden, wobei das Klebeband am Sensorelement bleibt und eine Klebeschicht bildet und die übrigen Sensorelemente am Abdeckstreifen verbleiben. Das Durchtrennen der Sensorelemente kann auch am Klebeband erfolgen, der verbindende Abdeckstreifen jedoch sollte nicht durchtrennt werden für eine einfachere zusammenhängende Handhabung.

Zur Herstellung eines vorbeschriebenen Sensorelements kann ein Verfahren vorsehen, dass ein Hohlprofil aus Sensorelement-Material hergestellt wird mit einem Querschnitt, der einer Seitenansicht des Sensorelements entspricht. Von diesem Hohlprofil werden dann einzelne Sensorelemente abgeschnitten bzw. abgelängt, wobei sie vorzugsweise jeweils gleich groß bzw. gleich breit sind. Ein solches Ablängen der Sensorelemente kann einerseits am Ort der Herstellung des Hohlprofils bzw. daran anschließend erfolgen. Alternativ kann vorgesehen sein, dass ein Hohlprofil an eine Bestückungsmaschine für einen Träger der Sensorelemente herangeführt wird und das Ablängen erst an der Bestückungsmaschine erfolgt, wodurch es leichter ist, die Sensorelemente mit einer bestimmten gewünschten Ausrichtung an den Träger heranzubringen.

Das Sensorelement wird in der Regel rechtwinklig und gerade von dem Hohlprofil abgelängt. Es kann aber auch mit gekrümmtem Schnitt abgelängt werden. Dabei kann aus einem längsorientierten Profil ein abgerundetes oder weitgehend rundes Sensorelement werden, ähnlich einem aufrecht stehenden Zylinder.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombination bei einer Ausführungsform der Erfindung und auf anderen Gebieten verwirklicht sein und vorteilhafte sowie für sich schutzfähige Ausführungen darstellen können, für die hier Schutz beansprucht wird.

Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Seitenansicht eines erfindungsgemäßen Sensorelements mit nach innen geknickten Seitenwandbereichen,
- Fig. 2: eine erfindungsgemäße Berührungsschaltereinrichtung mit einem Sensorelement entsprechend Fig. 1 zwischen einer Leiterplatte und einer Bedienfläche mit aufgelegtem Finger,
- Fig. 3 bis 7: weitere Abwandlungen von Sensorelementen und
- Fig. 8: eine Berührungsschaltereinrichtung ähnlich Fig. 2 mit einem Sensorelement entsprechend Fig. 7.

### Detaillierte Beschreibung der Ausführungsbeispiele

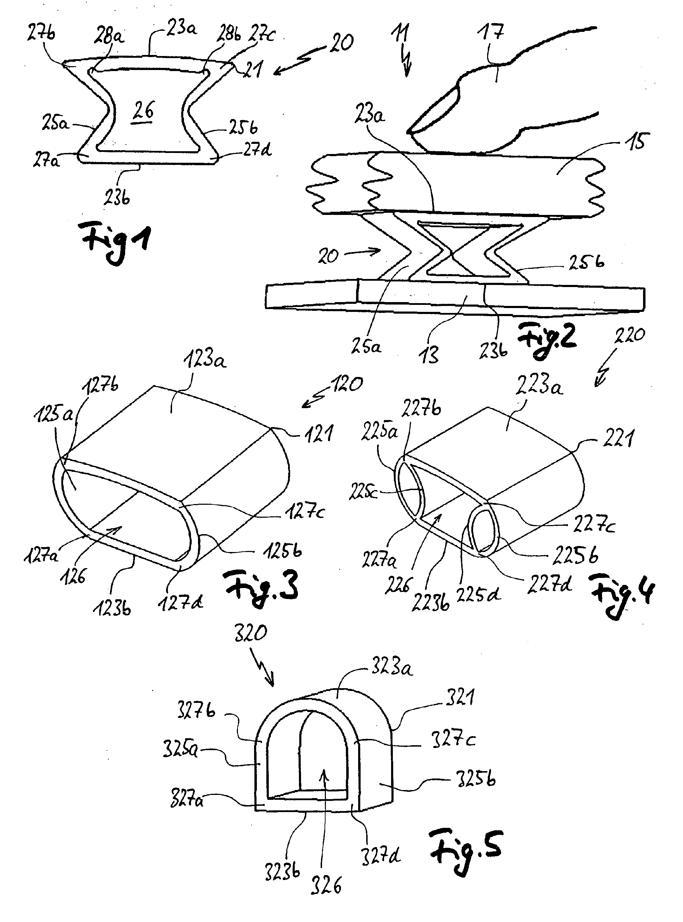

In Fig. 1 ist ein erfindungsgemäßes Sensorelement 20 in Seitenansicht dargestellt mit einem Sensorelementkörper 21. Daraus ist zu ersehen, dass das Sensorelement 20 bzw. der Sensorelementkörper 21 einstückig hergestellt ist mit einer oberen Deckfläche 23a und einer dieser gegenüberliegenden Bodenfläche 23b. Verbunden sind die beiden Flächen 23a und b durch den linken Seitenwandbereich 25a und den rechten Seitenwandbereich 25b. Diese Seitenwandbereiche umschließen einen Zwischenraum 26. Verbunden sind Deckfläche 23a und Bodenfläche 23b mit den Seitenwandbereichen 25a und b über die Verbindungen 27a bis d. Die Seitenwandbereiche 25a und b weisen ungefähr in der Mitte einen Knick nach innen auf.

Es ist zu erkennen, wie an der Verbindung 27b an dem Übergang von dem linken Seitenwandbereich 25a an die Deckfläche 23a eine Materialverdünnung 28a nach Art eines Einschnitts vorgesehen ist. Dasselbe gilt für die Verbindung 27c zwischen Deckfläche 23a und dem rechten Seitenwandbereich 25b mit der Materialverdünnung 28b. Diese Materialverdünnungen 28a und b sind hier an der Deckfläche 23a vorgesehen und sorgen für ein leichteres Verbiegen oder Abknicken der Seitenwandbereiche 25a und b nach innen beim Zusammendrücken des Sensorelements 20 im Einbauzustand.

Aus Fig. 1 ist der Querschnitt des Sensorelements 20 zu ersehen. Dieser Querschnitt kann bei einem vorbeschriebenen Hohlprofil, von welchem Sensorelemente 20 abgeschnitten werden, gleichbleibende Form aufweisen. Das Sensorelement 20 bzw. der Sensorelementkörper 21 kann aus einem vorbeschriebenen elastischen Material hergestellt werden, beispielsweise als eine Art feinporiger Schaum oder Gummi. Es kann durch Extrusion hergestellt werden mit beliebiger Länge.

In Fig. 2 ist eine erfindungsgemäße Berührungsschaltereinrichtung 11 dargestellt mit einem Sensorelement 20, das auf einer Leiterplatte 13 als Träger angeordnet ist und darauf mit der Bodenfläche 23b aufliegt. An der Deckfläche 23a liegt eine Bedienfläche 15 an. Der Abstand von Leiterplatte 13 zu Bedienfläche 15 ist ein Stück kleiner als die Höhe des Sensorelements 20 im entspannten Zustand gemäß Fig. 1, so dass das Sensorelement 20 in Fig. 2 zusammengedrückt ist. Die Verringerung der Höhe des Sensorelements 20 kann etwa 15% betragen.

Die Leiterplatte 13 kann gemäß Stand der Technik eine elektrische Verbindung zu dem Sensorelement 20 bilden durch oben aufgebrachte, evtl. metallisierte Kontaktfelder. Sie kann auch noch eine Ansteuerung bzw. Auswertung für das Sensorelement und eventuell die gesamte Berührungsschaltereinrichtung 11 oder ein Elektrogerät tragen.

Die Bedienfläche 15 ist beispielsweise eine Glasplatte oder Glaskeramikplatte und kann Teil eines Kochfelds oder einer sonstigen Oberfläche eines Elektrogeräts sein. Die Fläche des Sensorelements 20 an der Unterseite der Bedienfläche 15 bzw. der Deckfläche 23a bildet ein kapazitives Sensorelement bzw. eine Platte eines Kondensators, wie dies aus dem Stand der Technik bekannt ist. Der Hohlraum des Sensorelements ist axial zwischen den Platten ausgerichtet. Ein oben auf die Bedienfläche 15 aufgelegter Finger 17 kann von der Berührungsschaltereinrichtung 11 erkannt werden zum Auslösen einer Schaltfunktion odgl..

Wie aus Fig. 2 auch zu erkennen ist, wird durch das Zusammendrücken des Sensorelements 20 die in Fig. 1 leicht gewölbt dargestellte Deckfläche 23a so plan wie die Unterseite der Bedienfläche 15. Des Weiteren knicken die nach innen gebogenen Seitenwandbereiche 25a und 25b stärker ein nach Art einer Feder. Es ist leicht zu erkennen, dass der Kraftaufwand für das Zusammendrücken eines solchen Sensorelements 20 bei gleichzeitiger Elastizität erheblich geringer ist als bei einem aus Vollmaterial bestehendem Sensorelementkörper oder einem gemäß der DE 10 250 395 A1. Gleichzeitig wird erreicht, dass eine entsprechend große elektrisch leitfähige Fläche, nämlich die Deckfläche 23a, an der Unterseite der Bedienfläche 15 anliegt und über die ebenfalls elektrisch leitfähigen Seitenwandbereiche 25a und b und die Bodenfläche 23b mit einer Ansteuerung bzw. Auswertung verbunden ist.

Es wird darauf hingewiesen, dass bei der Berührungsschaltereinrichtung 11 die Leiterplatte 13 und die Bedienfläche 15 derart fest miteinander verbunden sind, dass ihr Abstand zueinander stets gleich bleibt. Toleranzen gleichen die Federeigenschaften des Sensorelements aus. In der dargestellten Ausführungsform hängt dieser Abstand nicht von dem Auflegen seines Fingers 17 ab, wobei dies grundsätzlich auch möglich ist.

In Fig. 3 ist als Abwandlung ein Sensorelement 120 dargestellt mit einem Sensorelementkörper 121, der wiederum ähnlich Fig. 1 eine obere Deckfläche 123a und eine untere Bodenfläche 123b aufweist. Deckfläche 123a und Bodenfläche 123b sind in Abweichung von Fig. 1 miteinander verbunden über nach außen gewölbte Seitenwandbereiche 125a und 125b, wobei sie relativ gleichmäßig gerundet bzw. gewölbt sind, so dass sich ein niedriger, tonnenartiger Körper ergibt. Wird ein solches Sensorelement 120 zusammengedrückt, beispielsweise in eine Berührungsschalteereinrichtung gemäß Fig. 2 eingebaut, so biegen sich die Seitenwandbereiche 125a und b etwas stärker nach außen.

In Fig. 4 ist als weitere Abwandlung ein Sensorelement 220 dargestellt mit einem Sensorelementkörper 221, der zwar ähnlich aufgebaut ist wie derjenige aus Fig. 3. Zusätzlich zu den nach außen gewölbten Seitenwandbereichen 225a und b sind aber nach innen gewölbte Seitenwandbereiche 225c und 225d vorgesehen, und zwar alle jeweils als Teilseitenwandbereiche. Die Verbindung sämtlicher Seitenwandbereiche 225a bis d mit Deckfläche 223a und Bodenfläche 223b erfolgt jeweils in den Verbindungsbereichen 227a bis d und somit jeweils in etwa an einem Punkt. Die Seitenwandbereiche 225 a bis d bilden somit sozusagen Doppelwände mit jeweils zwei Teilseitenwandbereichen. Beim Zusammendrücken des Sensorelements 220 werden die nach außen gewölbten Teilseitenwandbereiche 225a und b noch stärker nach außen gewölbt und die nach innen gewölbten Teilseitenwandbereiche 225c und d noch stärker nach innen. Hierdurch kann erreicht werden, dass im Wesentlichen keine Verdrehung an den Verbindungen 227 bzw. den Übergängen zu Deckfläche 223a und Bodenfläche 223b hin stattfindet. Des Weiteren kann bei etwa gleichbleibenden Wandstärken die Federwirkung der Teilseitenwandbereiche 225 verstärkt werden, das Sensorelement 220 also nicht mehr so ganz leicht zusammengedrückt werden.

In Fig. 5 ist als weitere Abwandlung ein Sensorelement 320 dargestellt, bei dem von der unteren Bodenfläche 323b links und rechts Seitenwandbereiche 325a und b nahezu rechtwinklig nach oben abgehen. In einer bestimmten Höhe gehen die Seitenwandbereiche 325a und b übergangslos und ohne Verdünnung oder Verdickung der Wandstärke in die Deckfläche 323a über, die nach Art eines Teilkreises nach oben gewölbt ist. Auch ein derartiges Sensorelement 320 liegt im Rahmen der Erfindung. Es eignet sich vor allem auch dann, wenn eine darüber verlaufende Bedienfläche, gegen die das Sensorelement 320 gedrückt werden soll, nicht eben ist wie in Fig. 2 dargestellt ist, sondern ähnlich der Wölbung der oberen Deckfläche 323a gewölbt ist, vorteilhaft etwas schwächer. Auch dann bildet wiederum die direkt an der Unterseite der Bedienfläche anliegende Deckfläche 323a ein kapazitives Sensorelement wie zuvor beschrieben. Selbstverständlich ist es in Abwandlung von Fig. 5 leicht vorstellbar, die Deckfläche 323a auch kugelförmig nach oben zu wölben oder unter Umständen auch mit entsprechender Form nach unten in den Zwischenraum 326 hinein zu wölben.

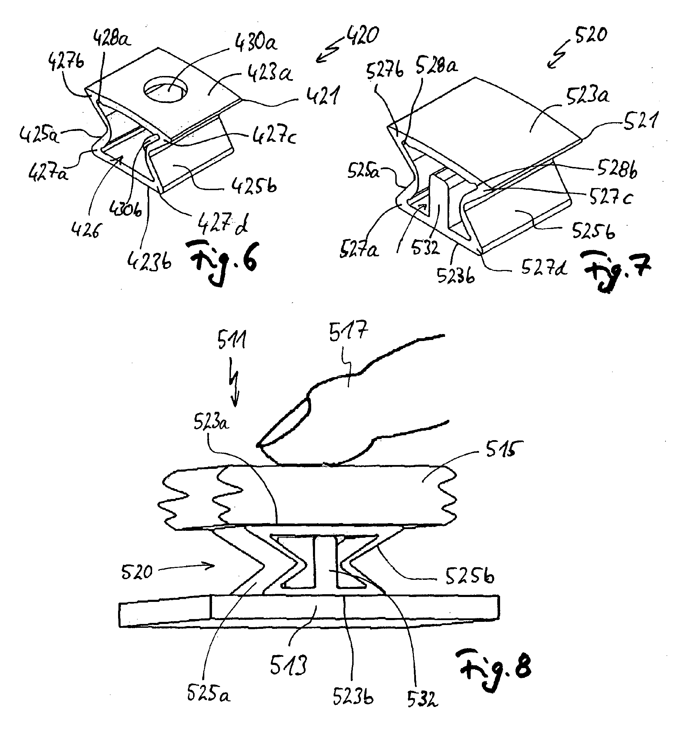

In Fig. 6 ist als weitere Abwandlung ein Sensorelement 420 dargestellt, das im Wesentlichen dem Sensorelement der Fig. 1 und 2 entspricht, allerdings mit der Modifikation, dass in der Deckfläche 423a und der Bodenfläche 423b jeweils eine axial fluchtende Ausnehmung 430a und 430b vorgesehen ist. Durch die untere Ausnehmung 430b kann eine von einer Leiterplatte ähnlich Fig. 2 abstehende LED oder ein Lichtleiter hindurchragen und ihr Licht durch die obere Ausnehmung 430a nach oben abgeben. Dies entspricht im Prinzip einer Längsbohrung gemäß der EP 859 467 A1. Es ist natürlich auch möglich, in Deckfläche oder Bodenfläche mehrere derartige Ausnehmungen vorzusehen.

In Fig. 7 ist als weitere Abwandlung ein Sensorelement 520 dargestellt, das auch von demjenigen der Fig. 1 und 2 ausgeht. Deckfläche 523a und Bodenfläche 523b sowie die Seitenwandbereiche 525a und b sind entsprechend Fig. 1 und 2 ausgebildet und miteinander verbunden. Der Unterschied besteht hier darin, dass mittig von der Bodenfläche 523b ein Vorsprung 532 nach oben absteht und auf die Deckfläche 523a zuläuft, jedoch einen gewissen Abstand dazu behält. Insbesondere beträgt die Höhe des Vorsprungs 523 etwa 75% der gesamten Höhe des Zwischenraums 526. Es ist auch zu erkennen, dass der Vorsprung 532 relativ stabil bzw. seine Dicke das zwei- bis fünffache der Wandstärke der Wandbereiche beträgt.

Das Sensorelement 520 aus Fig. 7 ist in Fig. 8 im eingebauten Zustand als Abwandlung von Fig. 2 dargestellt. Die Berührungsschaltereinrichtung 511 zeigt, dass hier die Bedienfläche 515 so weit an die Leiterplatte 513 angenähert ist, dass bei dem dazwischen befindlichen Sensorelement 520 der Vorsprung 532 an die innere Unterseite der Deckfläche 523a angedrückt ist. Dies bildet sozusagen eine Art Anschlag für das Zusammendrücken des Sensorelements 520. Ein weiteres Zusammendrücken ist zwar noch möglich, jedoch steigt die hierfür notwendige Kraft stark bzw. um ein Vielfaches an, da nun das Zusammendrücken bzw. Komprimieren des Vorsprungs 532 dazukommt.

In Erweiterung der Erfindung ist es auch möglich, dass ein Seitenwandbereich zwischen Deckfläche und Bodenfläche mehrere derartige Knicke oder Wölbungen aufweist, insbesondere nach Art einer Ziehharmonika odgl. bzw. ähnlich wie ein Faltenbalg. Auch hier kann ein derartiges Sensorelement aus einem Längsstrang mit gleichbleibendem Querschnitt hergestellt und abgeschnitten werden.

## Patentansprüche

1. Sensorelement (20, 120, 220, 320, 420, 520) für einen vorzugsweise kapazitiven Berührungsschalter (11, 511), wobei das Sensorelement (20, 120, 220, 320, 420, 520) einen Sensorelementkörper (21, 121, 221, 321, 421, 521) aus elastischem Material aufweist und der Sensorelementkörper zumindest bei Einbau in den Berührungsschalter (11, 511) eine Deckfläche (23a, 123a, 223a, 323a, 423a, 523a) und eine dieser gegenüberliegende, im wesentlichen dazu parallele Bodenfläche (23b, 123b, 223b, 323b, 423b, 523b) aufweist, **dadurch gekennzeichnet, dass** das Sensorelement (20, 120, 220, 320, 420, 520) kastenartig ausgebildet ist mit Wandbereichen, die um einen größeren Zwischenraum herum verlaufend zusammenhängend ausgebildet sind, wobei die Deckfläche (23a, 123a, 223a, 323a, 423a, 523a) und die Bodenfläche (23b, 123b, 223b, 323b, 423b, 523b) je von einem Stirnwandbereich gebildet sind und Deckfläche und Bodenfläche miteinander über Seitenwandbereiche (25a/b, 125a/b, 225a/b, 325a/b, 425a/b, 525a/b) verbunden sind.

2. Sensorelement nach Anspruch 1, **dadurch gekennzeichnet, dass** die Wandstärken der Wandbereiche (23a/b, 25a/b, 123a/b, 125a/b, 223a/b, 225a/b, 323a/b, 325a/b, 423a/b, 425a/b, 523a/b, 525a/b), insbesondere auch die Seitenwandbereiche (25a/b, 125a/b, 225a/b, 325a/b, 425a/b, 525a/b), im wesentlichen unveränderlich sind und vorzugsweise jeweils in etwa gleich sind.

3. Sensorelement nach Anspruch 1 oder 2, **dadurch gekennzeichnet, dass** die Wandstärken der Seitenwandbereiche (25a/b, 125a/b, 225a/b, 325a/b, 425a/b, 525a/b) im wesentlichen gleichbleibend sind und insbesondere relativ dünn sind, wobei vorzugsweise gegenüberliegende Seitenwandbereiche spiegelbildlich identisch ausgebildet sind.

4. Sensorelement nach einem der vorhergehenden Ansprüche, **dadurch gekennzeichnet, dass** an den Übergängen zwischen Deckfläche und Bodenfläche (23a/b, 423a/b, 523a/b) und Seitenwandbereichen (25a/b, 425a/b, 525a/b) Materialverdünnungen (28a/b, 428a/b, 528a/b) vorgesehen sind.

5. Sensorelement nach einem der vorhergehenden Ansprüche, **dadurch gekennzeichnet, dass** die Wandstärken der Seitenwandbereiche (25a/b, 125a/b, 225a/b, 325a/b, 425a/b, 525a/b) etwa 5% bis 10% der Breite oder Höhe des Sensorelements (20, 120, 220, 320, 420, 520) betragen, insbesondere etwa 0,5mm bis 2mm.

6. Sensorelement nach einem der vorhergehenden Ansprüche, **dadurch gekennzeichnet, dass** Deckfläche und Bodenfläche (23a/b, 123a/b, 223a/b, 423a/b, 523a/b) im Wesentlichen eben und parallel zueinander ausgebildet sind, wobei vorzugsweise die Seitenwandbereiche (25a/b, 125a/b, 225a/b, 425a/b, 525a/b) gebogen bzw. gewölbt ausgebildet sind.

7. Sensorelement nach Anspruch 6, **dadurch gekennzeichnet, dass** mindestens ein Seitenwandbereich (125/b, 225a/b) von einer Mitte des Sensorelements (120, 220) weg nach außen gewölbt ist, wobei vorzugsweise die Wölbung zwischen 5% und 20% der Breite des Sensorelements beträgt.

8. Sensorelement nach Anspruch 6, **dadurch gekennzeichnet, dass** mindestens ein Seitenwandbereich (25a/b, 225a/b, 425a/b, 525a/b) zu einer Mitte des Sensorelements (20, 220, 420, 520) hin nach innen gewölbt ist, wobei vorzugsweise die Wölbung zwischen 5% und 20% der Breite des Sensorelements beträgt.

9. Sensorelement nach einem der Ansprüche 6 bis 8, **dadurch gekennzeichnet, dass** mindestens ein Seitenwandbereich (25a/b, 125a/b, 225a/b, 425a/b, 525a/b) in einem Winkel von 35° bis 80° zu Deckfläche oder Bodenfläche (23a/b, 123a/b, 223a/b, 423a/b, 523a/b) steht, insbesondere in einem Winkel von 40° bis 70°, wobei vorzugsweise sämtliche Verbindungen (27a-d, 127a-d, 227a-d, 427a-d, 527a-d) zwischen Deckfläche und Bodenfläche und den Seitenwandbereichen den gleichen Winkel zueinander aufweisen.

10. Sensorelement nach einem der vorhergehenden Ansprüche, **dadurch gekennzeichnet, dass** ein Seitenwandbereich (225a/b) doppelwandig ausgebildet ist mit zwei Teilseitenwandbereichen (225a-d), die voneinander weggewölbt sind und an ihren Enden miteinander verbunden sind, wobei vorzugsweise die Verbindung (227a-d) der Enden der Teilseitenwandbereiche (225a-d) miteinander auch die Verbindung mit Deckfläche oder Bodenfläche (223a/b) ist.

11. Sensorelement nach einem der vorhergehenden Ansprüche, **dadurch gekennzeichnet, dass** das Sensorelement (20, 120, 220, 320, 420, 520) elektrisch leitfähig ist.

12. Sensorelement nach Anspruch 11, **dadurch gekennzeichnet, dass** die Bodenfläche (23b, 123b, 223b, 323b, 423b, 523b) zur elektrischen Kontaktierung an eine Ansteuerung und/oder Auswertung kleiner ist als die Deckfläche (23a, 123a, 223a, 323a, 423a, 523a), die die Berührungsfläche für den Berührungsschalter (11, 511) bildet oder ein Teil des Berührungsschalters ist.

13. Sensorelement nach einem der vorhergehenden Ansprüche, **gekennzeichnet durch** eine axial fluchtende Ausnehmung (430a/b) in Deckfläche und/oder Bodenfläche (423a/b), vorzugsweise **durch** eine Mitte des Sensorelements (420), wobei insbesondere die Fläche der Ausnehmung (430a/b) etwa 10% bis 25% der Fläche von Deckfläche oder Bodenfläche (423a/b) beträgt.

14. Sensorelement nach einem der Ansprüche 1 bis 12, **dadurch gekennzeichnet, dass** von einem Stirnwandbereich (523b) ein Vorsprung (532) in den Zwischenraum (526) absteht in Richtung auf den anderen Stirnwandbereich (523a) zu, wobei vorzugsweise die Höhe des Vorsprungs (532) etwa 50% bis 80% des Abstands der Stirnwandbereiche (523a/b) voneinander im nicht-komprimierten bzw. nicht-eingebautem Zustand beträgt.

15. Berührungsschaltereinrichtung (11, 511) mit mehreren Sensorelementen (20, 120, 220, 320, 420, 520) nach einem der vorhergehenden Ansprüche, wobei die Sensorelemente nebeneinander auf einem Träger wie einer Leiterplatte (13, 513) odgl. angeordnet sind und an einer Bedienfläche (15, 515) anliegen.

16. Berührungsschaltereinrichtung nach Anspruch 15, **dadurch gekennzeichnet, dass** die Sensorelemente (20, 120, 220, 320, 420, 520) auf den Träger (13, 513) aufgeklebt sind mittels eines doppelseitigen Klebebandes, wobei vorzugsweise das doppelseitige Klebeband auf dem Träger fixiert ist vor dem Aufsetzen der Sensorelemente.

17. Verfahren zur Herstellung eines Sensorelements (20, 120, 220, 320, 420, 520) nach einem der Ansprüche 1 bis 14, **dadurch gekennzeichnet, dass** ein Hohlprofil aus Sensorelement-Material hergestellt wird mit einem Querschnitt eines Sensorelements, und von dem Hohlprofil einzelne Sensorelemente (20, 120, 220, 320, 420, 520) abgelängt werden.

18. Verfahren nach Anspruch 17, **dadurch gekennzeichnet, dass** das Ablängen der Sensorelemente (20, 120, 220, 320, 420, 520) von dem Hohlprofil direkt an einer Bestückungsmaschine für die Sensorelemente auf einen Träger wie eine Leiterplatte (13, 513) odgl. erfolgt.

19. Verfahren nach Anspruch 17 oder 18, **dadurch gekennzeichnet, dass** das Sensorelement (20, 120, 220, 320, 420, 520) mit einem gekrümmten bzw. abgerundeten Schnitt abgeschnitten wird, vorzugsweise derart, dass das Sensorelement an der Seite angenähert rund ist.
